# EUROPEAN PATENT SPECIFICATION

(11) **EP 1 566 984 B1**
(45) Date of publication and mention of the grant of the patent: **27.06.2007**
(21) Application number: 05250718.3
(22) Date of filing: 08.02.2005
(51) Int. Cl.: H04Q 7/38, H04M 3/487

(54) **A method of delivering multimedia associated with a voice link**
Verfahren zum Übermitteln von mit einer Sprachverbindung assoziierten Multimedien
Procédé pour la délivrance de multimédia associés avec une liaison vocale

(30) Priority: 20.02.2004 US 783308
(43) Date of publication of application: 24.08.2005
(73) Proprietor: LUCENT TECHNOLOGIES INC., Murray Hill, New Jersey 07974-0636 (US)
(72) Inventor: Benno, Steven A., Towaco, NJ 07082 (US); Brunetti, Robert, Munster Indiana 46321 (US); Capetz, Jon J., Florham Park, NJ 07932 (US); Hsi, Teh-Li, Florham Park, NJ 07932 (US); Isukapalli, Ramana, Edison, NJ 08820 (US); Kanwal, Sarbmeet Singh, Holmdel, NJ 07733 (US); Reizner, Laura S., Lisle Illinois 60532 (US)
(74) Representative: Sarup, David Alexander

(56) References cited:
- WO-A-01/06679
- WO-A-02/089448
- US-A1- 2003 156 687
- US-B1- 6 222 826

## Description

### BACKGROUND OF THE INVENTION

### I. FIELD OF THE INVENTION

The present invention relates to telecommunications, and more particularly, to wireless communications.

### II. DESCRIPTION OF THE RELATED ART

Wireless communications systems provide wireless service to a number of wireless or mobile units situated within a geographic region. The geographic region supported by a wireless communications system is divided into spatially distinct areas commonly referred to as "cells." Each cell, ideally, may be represented by a hexagon in a honeycomb pattern. In practice, however, each cell may have an irregular shape, depending on various factors including the topography of the terrain surrounding the cell. Moreover, each cell is further broken into two or more sectors. Each cell is commonly divided into three sectors, each having a range of about 120 degrees, for example.

A conventional cellular system comprises a number of cell sites or base stations geographically distributed to support the transmission and reception of communication signals to and from the wireless or mobile units. Each cell site handles voice communications within a cell. Moreover, the overall coverage area for the cellular system may be defined by the union of cells for all of the cell sites, where the coverage areas for nearby cell sites overlap to ensure, where possible, contiguous communication coverage within the outer boundaries of the system's coverage area.

Each base station comprises at least one radio and at least one antenna for communicating with the wireless units in that cell. Moreover, each base station also comprises transmission equipment for communicating with a Mobile Switching Center ("MSC"). A mobile switching center is responsible for, among other things, establishing and maintaining calls between the wireless units, between a wireless unit and a wireline unit through a public switched telephone network ("PSTN"), as well as between a wireless unit and a packet data network ("PDN"), such as the Internet. A base station controller ("BSC") administers the radio resources for one or more base stations and relays this information to the MSC.

When active, a wireless unit receives signals from at least one base station over a forward link or downlink and transmits signals to at least one base station over a reverse link or uplink. Several approaches have been developed for defining links or channels in a cellular communication system, including time-division multiple access ("TDMA"), orthogonal-frequency division multiple access ("OFDMA") and code-division multiple access ("CDMA"), for example.

In TDMA communication systems, the radio spectrum is divided into time slots. Each time slot is designed to allow only one user to transmit and/or receive in this scheme. Thusly, TDMA may require precise timing between the transmitter and receiver so that each user may transmit their information during their allocated time.

In a CDMA scheme, each wireless channel is distinguished by a distinct channelization code (e.g., spreading code, spread spectrum code or Walsh code). Each distinct channelization code is used to encode different information streams. These information streams may then be modulated at one or more different carrier frequencies for simultaneous transmission. A receiver may recover a particular stream from a received signal using the appropriate channelization code to decode the received signal.

In OFDMA systems, a carrier signal may be defined by a number (e.g., 1024) of sub-carriers or tones transmitted using a set of mathematically timed orthogonal continuous waveforms. Each wireless channel may be distinguished by a distinct channelization tone. By employing continuous waveforms, the transmission and/or reception of the tones may be achieved because their orthogonality prevents them from interfering with one another.

Currently, wireless voice traffic is typically carried over circuit- switched ("CS") type networks. The reliance on CS type networks is likely to continue over at least the short run, as plans to put voice traffic onto the packet-switched ("PS") type network have been pushed out in time by most wireless service providers ("WSPs"). WSPs, however, have been actively upgrading their networks to add new packet-switched data capabilities, as well as expand voice capacities in the hopes of generating more revenue.

One area for revenue generation that has not been fully explored by WSPs involves the close collaboration of voice, carried over a CS type network, in combination with data/multimedia, carried over a PS type network. CS and PS networks are relatively independent of each other from the end-user and services points of view. To date, services and/or applications offered by WSPs use the strengths of one type network to the exclusion of the other. Consequently, end-users may not the benefits or enhanced user experience offered by the simultaneous use of both network types. WSPs have not, therefore, derived additional revenue from any enhanced services from the simultaneous use of both network types. Moreover, it may be said that WSPs' networks have not been utilized to their fullest potential.

Patent Cooperation Treaty (PCT) Patent Application No. WO 01/06679 relates to a method and system for providing customized information to a calling subscriber during a call setup process, that is, while the subscriber is waiting for a called party's answer after making a call setup request. The application provides an information provision apparatus, interconnecting with an exchange, for providing the realtime customized information to an originating subscriber. The apparatus capable of connecting the Internee is coupled with a short message service center through a predetermined closed network. The mobile subscriber can make a new subscription for the information provision service on the Internet. The subscription state is stored in a homo location register (HLR). If the subscriber makes a call, the exchange interconnected with the apparatus executes the service to the originating subscriber based on the subscription information of the HLR. The service is continued till a called party answers to the call. The apparatus supplies access information with which the originating subscriber may obtain more detailed information additionally. The access information including a telephone number, URL, etc. is provided to the originating subscriber through the short message service center. The customized information which the subscriber receives can be selected by the subscriber on the Internet, or alternated according to the service subscriber's information or the subscriber's location information automatically.

Patent Cooperation Treaty (PCT) Patent Application No. WO 02/089448 relates to a method for processing a request from a first terminal to establish a communication session between the first terminal and a second terminal, the first terminal and the second terminal being operable to communicate via a telecommunication network, the method comprising: receiving at the telecommunication network a request from the first terminal to establish a communication session with the second terminal; determining whether the second terminal is available to support the communication session; and if the second terminal is determined not to be available to support the communication session, transmitting to the first terminal the address of a data set corresponding to the second terminal.

United States Patent No. 6,222,826 relates to a method and apparatus for establishing multimedia calls over an intelligent telecommunications network in which the calls are requested through an internetwork of client computers and server computers and the internetwork of client computers and server computers is further connected to the intelligent telecommunications network. The method involves: 1) a caller generating a request for a call utilizing the internetwork to initiate the request; 2) delivering multimedia and/or audiovisual presentations(s) to the caller via the internetwork and/or public switched telephone network (PSTN); and 3) completing a circuit switched telephone call between the caller and a destination user subsequent to the delivery of the presentations(s) wherein the call is placed from within the intelligent network itself. In this manner, one or more multimedia advertisements or other presentations are delivered to the originating caller before completion of the requested call.

In view of the above considerations, a method is needed to support the service to both network types. Moreover, a demand exists for a method for cooperatively providing voice service(s), carried over a CS type network, with data/multimedia service(s), carried over a PS type network, for example.

### SUMMARY OF THE INVENTION

Methods according to the present invention are set out in the independent claims to which the reader is now referred. Preferred features are laid out in the dependent claims.

The present invention provides a method of providing service to multiple network types by a wireless unit in the context of person-to-person voice calling. More particularly, the present invention provides a method for cooperatively providing voice service(s), carried over a circuit-switched ("CS") type network, with multimedia service(s), carried over a packet-switched ("PS") type network to a wireless unit. For the purposes of the present invention, a multimedia service(s) includes the delivery of multimedia content, such as a video clip(s), a web page(s), as well as data services, such as the delivery of a non-multimedia content type data file(s), for example. Moreover, it should be noted that providing collaboration of voice service(s) with multimedia service(s), as stated herein, includes communication between a calling-from-party and a calling-to-party, one or both of which may be directed from a wireless or wireline unit.

In one embodiment, a method of the present invention involves the communication between a calling-from-party and a calling-to-party. The method includes the step of receiving an initiation signal from the calling-from-party for identifying the calling-to-party. In response to verifying the identity of the calling-to-party as a service subscriber in a database, the method selects multimedia content to be transmitted to the calling-from-party. A voice link may then be established to the calling-to-party in response to the initiation signal from the calling-from-party. Thereafter, the initiation signal may be bridged to establish a voice link between the calling-from-party the calling-to-party. This bridging may rely on the previously established voice link.

In another embodiment, a method of the present invention involves the communication between a calling-from-party and a calling-to-party. The method includes the step of transmitting a uniform resource locator to the calling-from-party in response to an initiation signal transmitted from the calling-from-party. The uniform resource locator may be transmitted over a data link (e.g., data session). The uniform resource locator identifies a location where multimedia content may be accessed by the calling-from-party if the calling-to-party is a service subscriber according to a database of service subscribers. Subsequently, another data link (e.g., data session) may be established for the downlink of the multimedia content. A voice link may then be established to the calling-to-party in response to the initiation signal from the calling-from-party. Thereafter, the initiation signal may be bridged to establish a voice link between the calling-from-party and the calling-to-party. This bridging may rely on the previously established voice link. In response to establishing a voice link between the calling-from-party and the calling-to-party, the established data links (e.g., data sessions) may be terminated.

These and other embodiments will become apparent to those skilled in the art from the following detailed description read in conjunction with the appended claims and the drawings attached hereto.

### BRIEF DESCRIPTION OF THE DRAWINGS

The present invention will be better understood from reading the following description of non-limiting embodiments, with reference to the attached drawings, wherein below:
**FIG.1** depicts a flow chart of an embodiment of the present invention;
**FIG. 2** depicts a flow chart of another embodiment of the present invention;
**FIG. 3** depicts a call flow supportive of the present invention;
**FIG. 4** depicts a flow chart of an aspect of the present invention;
**FIG. 5** depicts a flow chart of yet another embodiment of the present invention; and
**FIG. 6** depicts a flow chart of still another embodiment of the present invention.

It should be emphasized that the drawings of the instant application are not to scale but are merely schematic representations, and thus are not intended to portray the specific dimensions of the invention, which may be determined by skilled artisans through examination of the disclosure herein.

### DETAILED DESCRIPTION

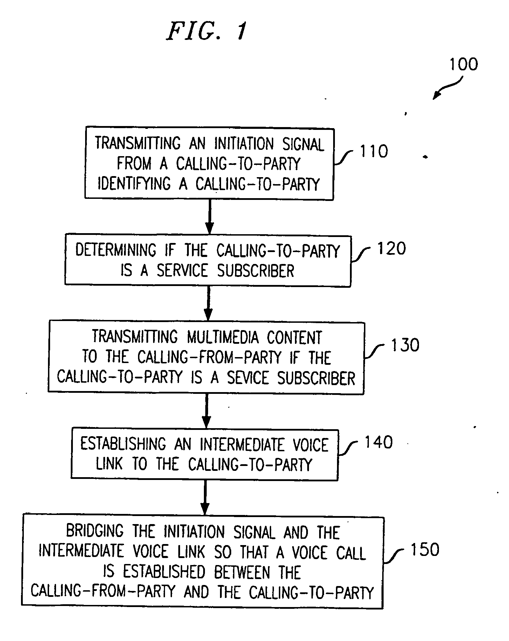

Referring to **FIG. 1,** a flow chart depicting one embodiment of the present invention is illustrated. Here, an algorithmic method **100** is shown for use with multiple network types. More particularly, method **100** depicts a sequence of steps in providing a collaboration of a voice service(s), carried over a circuit-switched ("CS") type network, with multimedia service(s), carried over a packet-switched ("PS") type network. For the purposes of the present invention, a multimedia service(s) includes the delivery of multimedia content, such as a video clip(s), a web page(s), as well as data services, such as the delivery of a non-multimedia content type data file(s), for example. Moreover, it should be noted that providing collaboration of voice service(s) with multimedia service(s), as stated herein, includes communication between a calling-from-party and a calling-to-party, one or both of which may be directed from a wireless or wireline unit.

Algorithmic method **100** initially provides for the step of transmitting an initiation signal from a calling-from-party (step **110).** This initiation signal is received by a communication network infrastructure element, such as a service control point/service node (e.g., server), for example. The step of transmitting the initiation signal may include entering the telephone number of the calling-to-party into the temporary memory of the calling-from-party's wireless or wireline unit. Thereafter, a corresponding send button or the like on the calling-from-party's wireless or wireline unit may be depressed so as to commence the sequence of steps in formulating a telephonic connection between the calling-from- and calling-to- parties. Consequently, the initiation signal identifies the calling-to-party.

Once the initiation signal is received by the communication network infrastructure, such as a service control point/service node, for example, a determination is made regarding the calling-to-party's status. More particularly, the service control point/service node may determine if the calling-to-party is a subscriber to the collaboration of voice and multimedia services (step **120).** This step of determining may include the step of looking up the telephone number of the calling-to-party in a database of service subscribers. If the calling-to-party is determined to be a service subscriber, algorithmic method **100** proceeds as depicted in the flow chart of **FIG. 1.** However, if the telephone number is not found within a database, the remainder of algorithmic method **100** may be terminated. In this case, the initiation signal triggers either a voice link or data link (e.g., sessions) connecting the calling-from-party with the calling-to-party.

After the calling-to-party is deemed a service subscriber, algorithmic method **100** may transmit multimedia content to the calling-from-party (step **130).** Here, the calling-to-party's identity (e.g., telephone number) may trigger the transmission of multimedia content to the calling-from-party over a downlink channel, for example. This multimedia content may, for example, include commercial matter, such as advertising and/or marketing material, or general information, for example, selected in response to the calling-to-party's identity.

In one embodiment of algorithmic method **100,** the step of transmitting multimedia content may include establishing a data link (e.g., data session) in the event the calling-to-party is found to be a service subscriber. This established data link (e.g., data session) might be formed between the calling-from-party and the service control point/service node (e.g., server). Here, the service control point/service node, and thus, the established data link (e.g., data session) may serve as the sole resource for the step of transmitting multimedia content to the calling-from-party. It should be noted that this established data link (e.g., data session) might be rely on a packet switched ("PS") type network.

With the transfer of the multimedia content to calling-from-party, algorithmic method **100** establishes an intermediate voice link to the calling-to-party (step **140).** The intermediate voice link may be established by the service control point/service node supporting the transmissions of multimedia content to the calling-from-party. Moreover, the intermediate voice link may rely on a circuit switched ("CS") type network.

In furtherance of desire for a collaboration of data (e.g., multimedia) service, carried over a PS type network, with the of voice service, carried over a CS type network, for example, the service control point/service node may thereafter bridge the initiation signal and the intermediate voice link (step **150).** Consequently, a voice call between the calling-from-party and the calling-to-party, as initiated at the onset of algorithmic method **100,** may be established and completed. It should be noted that this step of bridging may be performed after the transmission of multimedia content is concluded, though it is may also occur prior thereto.

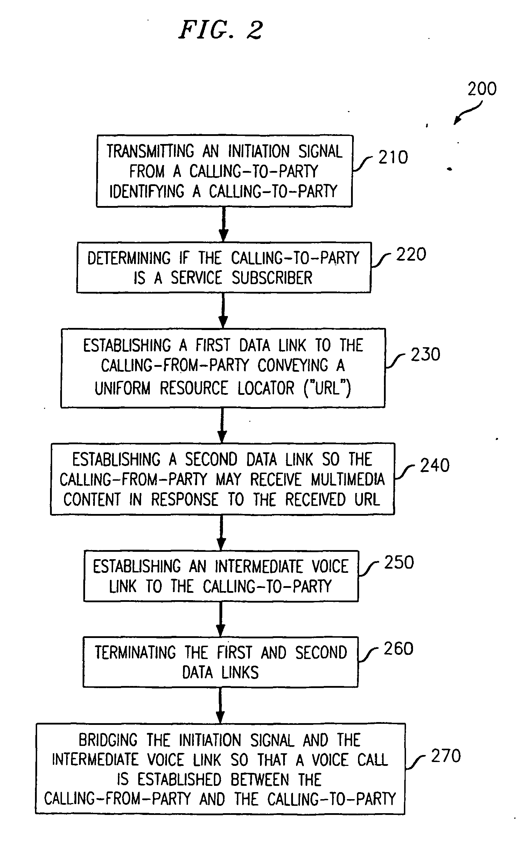

Referring to **FIG. 2,** a flow chart depicting a further embodiment of the present invention is illustrated. Here, another algorithmic method **200** is shown for use with multiple network types. Method **100** also depicts a sequence of steps in providing a collaboration of voice service(s), carried over a circuit-switched ("CS") type network, with multimedia service(s), carried over a packet-switched ("PS") type network.

Algorithmic method **200** initially provides for the step of transmitting an initiation signal from a calling-from-party (step **110).** This initiation signal is received by a communication network infrastructure element, such as a service control point/service node (e.g., server), for example. The step of transmitting the initiation signal may include entering the telephone number of the calling-to-party into the temporary memory of the calling-from-party's wireless or wireline unit. Thereafter, a corresponding send button or the like on the calling-from-party's wireless or wireline unit may be depressed so as to commence the sequence of steps in formulating a telephonic connection between the calling-from- and calling-to- parties. Consequently, the initiation signal identifies the calling-to-party.

Thereafter, a determination is made regarding the calling-to-party's identity. Here, the service control point/service node may determine if the calling-to-party is a subscriber to the collaboration of voice and multimedia services (step **220).** This step of determining may include the step of looking up the telephone number of the calling-to-party in a database of service subscribers. If the calling-to-party is determined to be a service subscriber, algorithmic method **200** proceeds as depicted in the flow chart of **FIG. 2.** In the alternative, should the telephone number of the calling-to-party not be found within a database, the offering of collaborative voice and multimedia services the remainder of algorithmic method **200** may be terminated. In this case, the initiation signal triggers either a voice link or data link (e.g., session) connecting the calling-from-party with the calling-to-party.

Once the calling-to-party is deemed a service subscriber, algorithmic method **200** establishes a data link (e.g., data session) to the calling-from-party (step **230).** Here, a uniform resource locator ("URL") may be selected in response to affirming if calling-to-party is a service subscriber. This URL may identify the location where multimedia content may be received by the calling-from-party over a downlink. It should be noted that the URL might be designated in advance by the calling-to-party, as part of the service subscription.

Subsequently, algorithmic method **200** establishes another data link (e.g., data session) (step **240).** With the URL information stored in memory, this subsequent data link (e.g., data session) may be used to forward the multimedia content, as intended by the calling-to-party, to the calling-from-party. Unlike algorithmic method **100** of **FIG. 1**, this additional data link (e.g., data session) is intended in the scenario where the multimedia content cannot be transmitted over the same data link (e.g., data session) in which the URL is communicated. This may also arise, for example, if the multimedia content is stored in a network element physically separated from the network element storing the URL.

With the transmission and reception of the multimedia content, algorithmic method **200** calls for establishing an intermediate voice link (step **250).** This intermediate voice link is established to the calling-to-party. The intermediate voice link may be established by the service control point/service node supporting the transmissions of multimedia content to the calling-from-party. Moreover, the intermediate voice link may rely on a circuit switched ("CS") type network.

It should be noted that in order to manage communication network resources, the aforementioned data links (e.g., data sessions) should be terminated in a logical sequence (step **260).** For example, the established data link (e.g., data session) for the transmission of the URL might be terminated in response to the establishing the intermediate voice link. Sometime thereafter, the established data link (e.g., data session) for the transmission of the multimedia content may also be terminated.

In furtherance of desire for a collaboration of data (e.g., multimedia) service, carried over a PS type network, for example, with the voice service, carried over a CS type network, the service control point/service node may thereafter bridge the initiation signal and the intermediate voice link (step **270).** Consequently, a voice call between the calling-from-party and the calling-to-party, as initiated at the onset of algorithmic method **200,** may be established and completed. It should be noted that this step of bridging may be performed after the transmission of multimedia content is concluded, though it is may also occur prior thereto.

### EXEMPLARY EMBODIMENTS

The present invention may provide a framework for the creation of enhanced services utilizing simultaneous CS voice and PS data capabilities of the network. The present invention may be based on widely used telecommunication signaling technologies and Internet standards, such as a session initiation protocol ("SIP"), for example. The present invention may combine both in a manner that may minimize the impact to the existing network infrastructure.

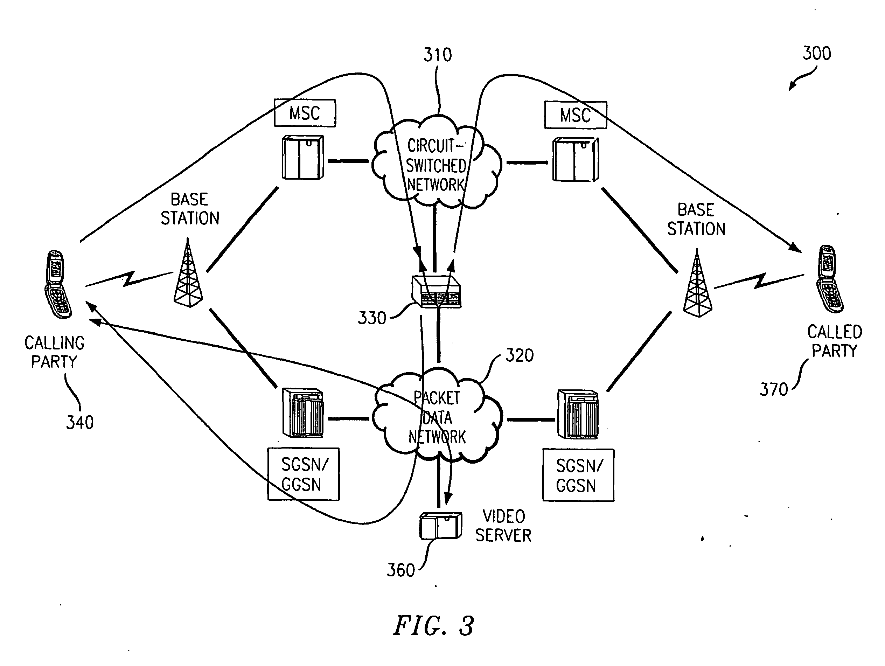

Referring to **FIG.** 3, a call flow **300** supportive of the present invention is illustrated. To facilitate call flow **300,** a wireless circuit switched ("CS") network **310** and a wireless packet switched ("PS") network **320** may be included as part of a network configuration. The network configuration may also include a service control point/service node **330** (e.g., eMRS, which acts as both a SCP and SN) with a user information database formed therein, a first wireless unit supportive of simultaneous CS voice and PS data **340** (e.g., class A terminal), and a video server **360** to support call flow **300.**

To realize the present invention, call flow **300** may process the call control when first wireless unit **340** initiates a voice call toward a called (wireline or wireless) receiving unit **370.** Alternatively, call flow **300** may process call control if it receives other triggers from the network - e.g., answer and/or disconnect. Depending on the nature of the trigger and the call state, the application of simultaneous CS voice and PS data may enable the performance of the appropriate tasks for the service, including, for example, initiating and/or terminating a data session.

First wireless unit **340** may have a client application(s) for handling the needs of a service, such as a session initiation protocol ("SIP") stack to process the message, establishing a multimedia session, and for streaming video and/or audio, controls, for example. User database may store user, service subscription, network and/or session information for each user. The application servers may provide specific service subscriber resources - e.g., a video clip(s), a web page(s), a data file(s) - for the user.

In one example of the call flow, a calling-from-party **340** may initiate a voice call to a calling-to-party **370** over circuit-switched network **310.** In turn, a Mobile Switching Center ("MSC") may then send the call control over to service control point/service node **330.** Thereafter, service control point/service node **330** may determine if the calling-to-party **370** is a subscriber to the multimedia service (e.g., video greeting service). If so, service control point/service node **330** may transmit a video clip URL to the calling-from-party **340.** This step may be realized through a SIP INVITE. Once the video clip URL is transmitted, calling-from-party **340** may receive the multimedia content associated with the URL from video server **360.** Video server **360**, as a result, may send the multimedia content (e.g., video greeting) to the calling-from-party **340.** Subsequently, service control point/service node **330** may initiate a voice call to calling-to-party **370.** After calling-to-party **370** the voice call is established from service control point/service node **330,** service control point/service node **330** may transmit a termination message (e.g., BYE) to calling-from-party **340** to terminate the SIP session in which the video clip may be transmitted. Thereafter, service control point/service node **330** may then bridge the two voice call legs together. Consequently, calling-from-party **340** and calling-to-party **370** may now have a complete voice conversation.

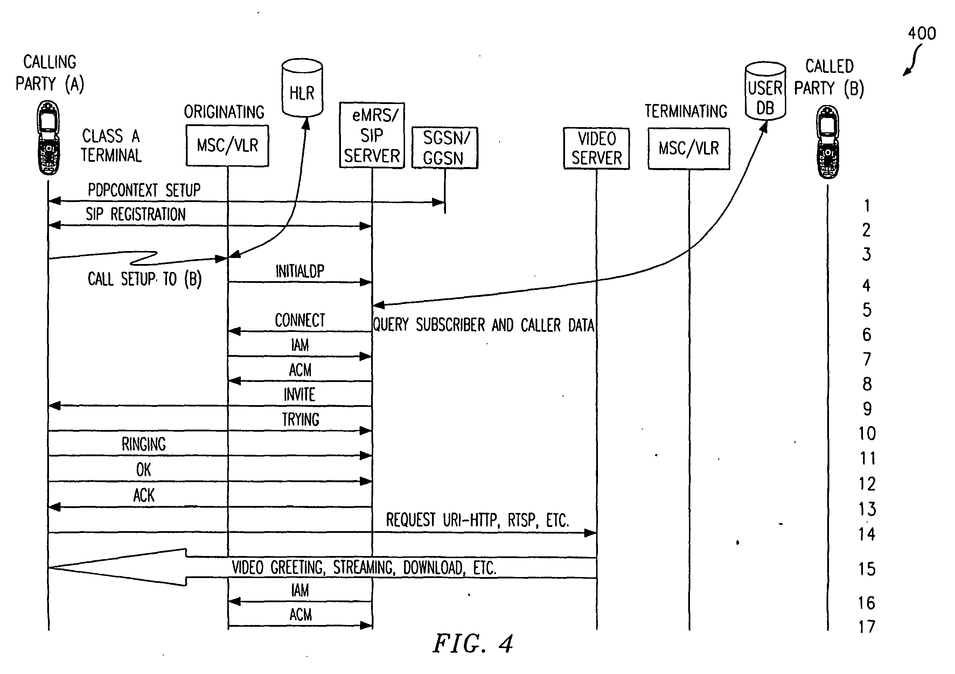

It should be noted that personal video greeting is merely one example of a multimedia service enabled by the present invention. This multimedia service may enable a subscriber to send a personalized video-greeting message to callers while the voice call is being connected. Referring to **FIG. 4,** a message flow **400** is illustrated in accordance with an exemplary personal video greeting service enabled with this framework. Message flow **400** may include a sequence of process steps, as follows:
1. Calling party (A) sets up a PDPContext;
2. Calling party (A) registers with a SIP registrar/server;
3. Calling party (A) initiated a voice call to called party (B), and the originating MSC queries the HLR for called party location and service subscription;
4. The GMSC detects the Termination Attempt Authorized trigger and sends an InitialDP message to the eMRS;
5. The eMRS (e.g., service control point/service node) queries a user database for subscriber and service subscription data - URL of the personal video, etc., and caller data, mapping of SIP URL to the caller MSISDN;
6. The eMRS responds with a Connect message;
7. The GMSC sends an IAM to extend the call to eMRS;
8. The eMRS responds with an ACM;
9. The eMRS initiates a SIP call to call party (A) by sending a INVITE message to calling party (A);
10. Calling party (A) responds with a trying message;
11. Calling party (A) responds with a ringing message;
12. Calling party (A) responds with an OK message;
13. The eMRS sends an ACK to calling party (A);
14. Calling party (A) requests video from the video server based on the URI included in the SIP message;
15. The video server streams the video greeting to calling party (A);
16. The eMRS initiates a new call to the called party by sending an IAM to the GMSC; and
17. The GMSC responds with an ACM.

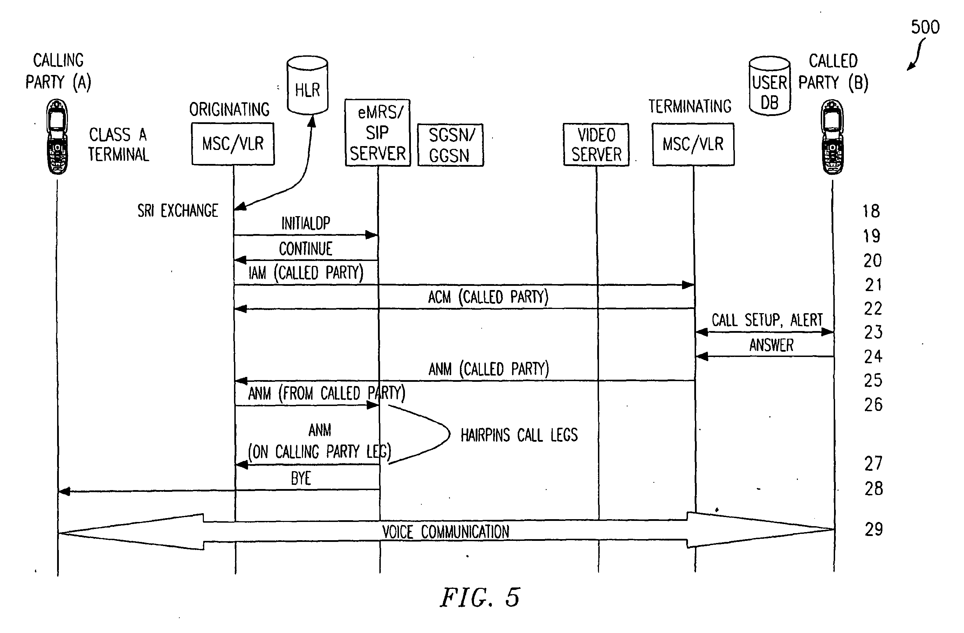

Referring to **FIG. 5,** a message flow **500** is illustrated in accordance with an exemplary personal video greeting service enabled with this framework. Message flow **500** continues the sequence of steps depicted in flow **400** of **FIG. 4** as follows:
18. The GMSC exchange SendRoutingInfo (SRI) message with HLR;
19. The GMSC sends an InitialDP message to an eMRS (e.g., service control point/service node);
20. The eMRS responds with a Continue message;
21. The GMSC sends the IAM to the VMSC;
22. The VMSC responds with an ACM;
23. The VMSC sets up the call to called party (B);
24. The called party answers;
25. The VMSC sends an ANM to the GMSC;
26. The GMSC informs eMRS that the called party answered with an ANM;
27. The eMRS hairpins the two call legs and sends an ANM to the GMSC on the calling party leg;
28. The eMRS sends a BYE message to the calling party (A) to terminate the SIP session. The SIP application then closes the video viewer; and
29. The voice communication begins.

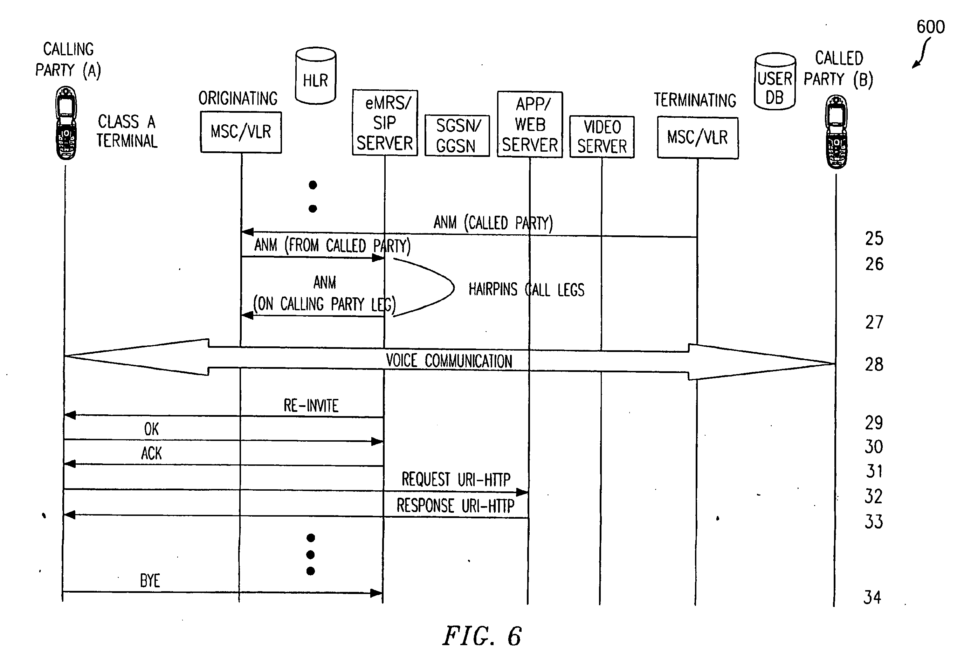

Referring to **FIG. 6,** a message flow **600** is illustrated in accordance with another exemplary approach. Message flow **600** is reflected in the following steps:
28. The voice communication begins;
29. The eMRS sends a re-Invite message with the URL of the application(s) to calling party (A);
30. The calling party (A) responds with an OK message;
31. The eMRS sends an ACK to calling party (A);
32. The calling party (A) request the URL of the application;
33. The application sends the response back to calling party (A); and
34. The calling party (A) sends a Bye message to the eMRS.

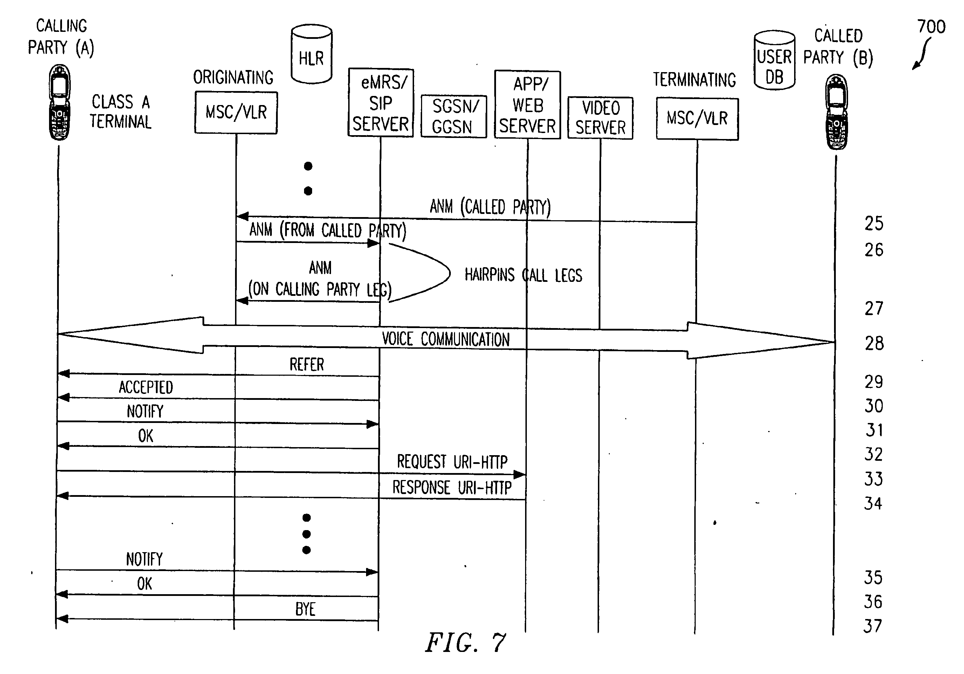

It should be noted that the principles reflected in the personal video greeting service detailed herein, for example, may be extended to other applications. Exemplary alternative applications may include on-line browsing/shopping with operator assistance. Referring to **FIG. 7,** a message flow **700** is shown. Message flow **700** illustrates a methodology for invoking an alternative application(s) after the initial video greeting is complete. Message flow **700,** incorporating the sequence of steps for delivering the personal video greeting, as depicted in message flow **400** of **FIG. 4** and flow **500** of **FIG. 5,** also includes the following additional steps:
28. The voice communication begins;
29. The eMRS (e.g., service control point/service node) sends a REFER message with the URL of the application(s) to calling party (A);
30. The calling party (A) responds with an ACCEPTED message;
31. The calling party (A) responds with a NOTIFY message;
32. The eMRS sends an OK to calling party (A);
33. The calling party (A) request the URL of the application;
34. The application sends the response back to calling party (A);
35. The calling party (A) sends a NOTIFY message to the eMRS;
36. The eMRS responds with an OK message; and
37. The eMRS sends a BYE message to the calling party (A).

While the particular invention has been described with reference to illustrative embodiments, this description is not meant to be construed in a limiting sense. It is understood that although the present invention has been described, various modifications of the illustrative embodiments, as well as additional embodiments of the invention, will be apparent to one of ordinary skill in the art upon reference to this description without departing from the scope of the invention, as recited in the claims appended hereto. Consequently, the method, system and portions thereof and of the described method and system may be implemented in different locations, such as the wireless unit, the base station, a base station controller and/or mobile switching center. Moreover, processing circuitry required to implemenf and use the described system may be implemented in application specific integrated circuits, software-driven processing circuitry, firmware, programmable logic devices, hardware, discrete components or arrangements of the above components as would be understood by one of ordinary skill in the art with the benefit of this disclosure. Those skilled in the art will readily recognize that these and various other modifications, arrangements and methods can be made to the present invention without strictly following the exemplary applications illustrated and described herein and without departing from the scope of the present invention It is therefore contemplated that the appended claims will cover any such modifications or embodiments as fall within the scope of the invention.

## Claims

1. A method of communication between a calling-from-party (340) and a calling-to-party (370), the method comprising:
enabling a data service over a first type of network (320) to operate with a voice service over a second type of network (310) different than the first type of network (320);
transmitting a uniform resource locator to the calling-from-party (340) in response to an initiation signal from the calling-from-party (340);
determining if the calling-to-party (370) is a service subscriber of the data service to receive multimedia content from the calling-from-party (340); and
establishing a voice link to the calling-to-party (370) in response to the initiation signal from the calling-from-party (340).

2. The method of Claim 1, wherein the uniform resource locator identifies a location for a multimedia content, and wherein the step of transmitting a uniform resource locator comprises:
establishing a first data session for downloading the multimedia content;
looking up the calling-to-party(370) in a database (350) of service subscribers; and
selecting the uniform resource locator if the calling-to-party (370) is at least one of the service subscribers in the database (350).

3. A method of communication with a calling-to-party (370), the method comprising:
receiving a uniform resource locator associated with the calling-to-party (370) from a video server (360) in response to an initiation signal from a calling-from party (340);
enabling the calling-from-party (340) to determine whether the calling-to-party (370) is a service subscriber of a multimedia service; and
establishing a first data session from a service controlling node (330) to the calling-from-party (340) in response to the received uniform resource locator.

4. The method of Claim 3, wherein the step of receiving a uniform resource locator comprises:
establishing a second data session for receiving the uniform resource locator.

5. The method of Claim 4, wherein the uniform resource locator identifies a location for multimedia content to be received over the second data session, the multimedia content received over the second data session if the calling-to-party (370) is a service subscriber of a multimedia service, the method comprising:
bridging the initiation signal from the calling-from party into a voice link from the calling-from-party (340) to the calling-to-party (370);
terminating the established second data session prior to the step of bridging the initiation signal; and
terminating the established first data session after the step of terminating the established second data session.

6. A method of communication with a calling-from-party (340), the method comprising:
selecting multimedia content associated with a calling-to-party (370) to be forwarded to the calling-from-party (340) in response to identifying the calling-to-party (370), the multimedia content selected if the calling-to-party (370) is a service subscriber of a data service to receive multimedia content; and
establishing a voice link from the calling-from-party to the calling-to-party (370) in response to the identifying the calling-to-party (370) based on an initiation signal from the calling-from-party (340).

7. A method of communication between a calling-from-party (340) and a calling-to-party (370), the method comprising:
enabling a data service over a first type of network (320) to operate with a voice service over a second type of network (310) different than the first type of network (320);
receiving an initiation signal from the calling-from-party (340) identifying the calling-to-party (370);
determining if the calling-to-party(370) is a service subscriber of the data service to receive multimedia content;
transmitting multimedia content to the calling-from-party (340), the multimedia content selected in response to the identifying of the calling-to-party (370) to be a service subscriber of the data service to receive the multimedia content; and
establishing a voice link to the calling-to-party (370) in response to the initiation signal from the calling-from-party (340).

8. The method of Claims 1 or 7, comprising:
bridging the initiation signal from the calling-from-party(340) with the established voice link to the calling-to-party (370).

9. The method of Claim 7, wherein a uniform resource locator identifies a location for the selected multimedia content to be received from, and the step of transmitting multimedia content comprises:
transmitting a uniform resource locator;
looking up the calling-to-party (370) in a database (350) of service subscribers;
selecting the uniform resource locator if the calling-to-party (370) is at least one of the service subscribers in the database (350); and
establishing a first data session for the transmission of the multimedia content.

10. The method of Claims 2 or 9, wherein the step of transmitting a uniform resource locator comprises:
establishing a second data session for transmitting the uniform resource locator to the calling-from-party (340);
terminating the established second data session in response to the step of establishing a voice link to the calling-to-party (370); and
terminating the established first data session after the step of terminating the established second data session.

## Patentansprüche

1. Kommunikationsverfahren zwischen einem A-Teilnehmer (340) und einem B-Teilnehmer (370) mit folgendem:
Ermöglichen, daß ein Datendienst über eine erste Art Netz (320) mit einem Sprachdienst über eine zweite Art Netz (310) betrieben wird, die sich von der ersten Art Netz (320) unterscheidet;
Übertragen einer URL-Adresse zum A-Teilnehmer (340) als Reaktion auf ein Einleitungssignal von dem A-Teilnehmer (340);
Bestimmen, ob der B-Teilnehmer (370) ein Dienstteilnehmer des Datendienstes zum Empfangen von Multimedieninhalt von dem A-Teilnehmer (340) ist; und
Herstellen einer Sprachverbindung zu dem B-Teilnehmer (370) als Reaktion auf das Einleitungssignal von dem A-Teilnehmer (340).

2. Verfahren nach Anspruch 1, wobei die URL-Adresse eine Stelle für einen Multimedieninhalt identifiziert und wobei der Schritt des Übertragens einer URL-Adresse folgendes umfaßt:
Herstellen einer ersten Datensitzung zum Herunterladen des Multimedieninhalts;
Nachschlagen des B-Teilnehmers (370) in einer Datenbank (350) von Dienstteilnehmern; und
Auswählen der URL-Adresse, wenn der B-Teilnehmer (370) mindestens einer der Dienstteilnehmer in der Datenbank (350) ist.

3. Kommunikationsverfahren mit einem B-Teilnehmer (370), mit folgendem:
Empfangen einer dem B-Teilnehmer (370) zugeteilten URL-Adresse von einem Videoserver (360) als Reaktion auf ein Einleitungssignal von einem A-Teilnehmer (340);
Ermöglichen, daß der A-Teilnehmer (340) bestimmt, ob der B-Teilnehmer (370) ein Dienstteilnehmer eines Multimediendienstes ist; und
Herstellen einer ersten Datensitzung von einem Dienststeuerungsknoten (330) zu dem A-Teilnehmer (340) als Reaktion auf die empfangene URL-Adresse.

4. Verfahren nach Anspruch 3, wobei der Schritt des Empfangens einer URL-Adresse folgendes umfaßt:
Herstellen einer zweiten Datensitzung zum Empfangen der URL-Adresse.

5. Verfahren nach Anspruch 4, wobei die URL-Adresse eine Stelle für über die zweite Datensitzung zu empfangenen Multimedieninhalt identifiziert, wobei der Multimedieninhalt über die zweite Datensitzung empfangen wird, wenn der B-Teilnehmer (370) ein Dienstteilnehmer eines Multimediendienstes ist, mit folgenden Schritten:
Überbrücken des Einleitungssignals vom A-Teilnehmer in eine Sprachverbindung von dem A-Teilnehmer (340) zu dem B-Teilnehmer (370);
Abschließen der hergestellten zweiten Datensitzung vor dem Schritt des Überbrückens des Einleitungssignals; und
Abschließen der hergestellten ersten Datensitzung nach dem Schritt des Abschließens der hergestellten zweiten Datensitzung.

6. Kommunikationsverfahren mit einem A-Teilnehmer (340), mit folgenden Schritten:
Auswählen von als Reaktion auf das Identifizieren des B-Teilnehmers (370) zum A-Teilnehmer (340) weiterzuleitendem, einem B-Teilnehmer (370) zugeordnetem Multimedieninhalt, wobei der Multimedieninhalt ausgewählt wird, wenn der B-Teilnehmer (370) ein Dienstteilnehmer eines Datendienstes zum Empfangen von Multimedieninhalt ist; und
Herstellen einer Sprachverbindung von dem A-Teilnehmer zum B-Teilnehmer (370) als Reaktion auf die Identifizierung des B-Teilnehmers (370) auf Grundlage eines Einleitungssignals von dem A-Teilnehmer (340).

7. Kommunikationsverfahren zwischen einem A-Teilnehmer (340) und einem B-Teilnehmer (370), mit folgenden Schritten:
Ermöglichen des Betreibens eines Datendienstes über eine erste Art Netz (320) mit einem Sprachendienst über eine sich von der ersten Art Netz (320) unterscheidende zweite Art Netz (310);
Empfangen eines Einleitungssignals von dem A-Teilnehmer (340), das den B-Teilnehmer (370) identifiziert;
Bestimmen, ob der B-Teilnehmer (370) ein Dienstteilnehmer des Datendienstes zum Empfangen von Multimedieninhalt ist;
Übertragen von Multimedieninhalt zu dem A-Teilnehmer (340), wobei der Multimedieninhalt als Reaktion auf das Identifizieren des B-Teilnehmers (370) als Dienstteilnehmer des Datendienstes zum Empfangen des Multimedieninhalts ausgewählt wird; und
Herstellen einer Sprachverbindung zu dem B-Teilnehmer (370) als Reaktion auf das Einleitungssignal von dem A-Teilnehmer (340).

8. Verfahren von Ansprüchen 1 oder 7, mit folgenden Schritten:
Überbrücken des Einleitungssignals von dem A-Teilnehmer (340) mit der hergestellten Sprachverbindung zu dem B-Teilnehmer (370).

9. Verfahren nach Anspruch 7, wobei eine URL-Adresse eine Stelle identifiziert, von der der ausgewählte Multimedieninhalt zu empfangen ist, und der Schritt des Übertragens von Multimedieninhalt folgendes umfaßt:
Übertragen einer URL-Adresse;
Nachschlagen des B-Teilnehmers (370) in einer Datenbank (350) von Dienstteilnehmern;
Auswählen der URL-Adresse, wenn der B-Teilnehmer (370) mindestens einer der Dienstteilnehmer in der Datenbank (350) ist; und
Herstellen einer ersten Datensitzung zur Übertragung des Multimedieninhalts.

10. Verfahren nach Ansprüchen 2 oder 9, wobei der Schritt des Übertragens einer URL-Adresse folgendes umfaßt:
Herstellen einer zweiten Datensitzung zum Übertragen der URL-Adresse zu dem A-Teilnehmer (340);
Abschließen der hergestellten zweiten Datensitzung als Reaktion auf den Schritt des Herstellens einer Sprachverbindung mit dem B-Teilnehmer (370); und
Abschließen der hergestellten ersten Datensitzung nach dem Schritt des Abschließens der hergestellten zweiten Datensitzung.

## Revendications

1. Procédé de communication entre un appelant (340) et un appelé (370), le procédé comprenant :
. l'activation d'un service de données sur un premier type de réseau (320) pour fonctionner avec un service vocal sur un second type de réseau (310) différent du premier type de réseau (320) ;
. la transmission d'un localisateur de ressource uniforme à l'appelant (340) en réponse à un signal de déclenchement de l'appelant (340) ;
. la détermination du fait que l'appelé (370) est ou non un abonné de service du service de données pour recevoir un contenu multimédia de l'appelant (340) ; et
. l'établissement d'une liaison vocale vers l'appelé (370) en réponse au signal de déclenchement de l'appelant (340).

2. Procédé selon la revendication 1, dans lequel le localisateur de ressource uniforme identifie un emplacement pour un contenu multimédia, et dans lequel l'étape de transmission d'un localisateur de ressource uniforme comprend :
. l'établissement d'une première session de données pour télécharger le contenu multimédia ;
. la recherche de l'appelé (370) dans une base de données (350) d'abonnés de service ; et
. la sélection du localisateur de ressource uniforme si l'appelé (370) est au moins un des abonnés de service dans la base de données (350).

3. Procédé de communication avec un appelé (370), le procédé comprenant :
. la réception d'un localisateur de ressource uniforme associé à l'appelé (370) d'un serveur vidéo (360) en réponse à un signal de déclenchement d'un appelant (340) ;
. le fait de permettre à l'appelant (340) de déterminer si l'appelé (370) est un abonné de service d'un service multimédia ; et
. l'établissement d'une première session de données d'un noeud de commande de service (330) vers l'appelant (340) en réponse au localisateur de ressource uniforme reçu.

4. Procédé selon la revendication 3, dans lequel l'étape de réception d'un localisateur de ressource uniforme comprend :
. l'établissement d'une seconde session de données pour recevoir le localisateur de ressource uniforme.

5. Procédé selon la revendication 4, dans lequel le localisateur de ressource uniforme identifie un emplacement pour un contenu multimédia à recevoir lors de la seconde session de données, le contenu multimédia étant reçu sur la seconde session de données si l'appelé (370) est un abonné de service d'un service multimédia, le procédé comprenant :
. la mise en relation du signal de déclenchement de l'appelant dans une liaison vocale de l'appelant (340) à l'appelé (370) ;
. la terminaison de la seconde session de données établie avant l'étape de mise en relation du signal de déclenchement ; et
. la terminaison de la première session de données établie après l'étape de terminaison de la seconde session de données établie.

6. Procédé de communication avec un appelant (340), le procédé comprenant :
. la sélection d'un contenu multimédia associé à un appelé (370) à transférer à l'appelant (340) en réponse à l'identification de l'appelé (370), le contenu multimédia étant sélectionné si l'appelé (370) est un abonné de service d'un service de données pour recevoir un contenu multimédia ; et
. l'établissement d'une liaison vocale de l'appelant vers l'appelé (370) en réponse à l'identification de l'appelé (370) sur la base d'un signal de déclenchement de l'appelant (340).

7. Procédé de communication entre un appelant (340) et un appelé (370), le procédé comprenant :
. le fait de permettre à un service de données sur un premier type de réseau (320) de fonctionner avec un service vocal sur un second type de réseau (310) différent du premier type de réseau (320) ;
. la réception d'un signal de déclenchement de l'appelant (340) identifiant l'appelé (370) ;
. la détermination du fait que l'appelé (370) est ou non un abonné de service du service de données pour recevoir un contenu multimédia ;
. la transmission d'un contenu multimédia à l'appelant (340), le contenu multimédia étant sélectionné en réponse à l'identification de l'appelé (370) comme abonné de service du service de données pour recevoir le contenu multimédia ; et
. l'établissement d'une liaison vocale vers l'appelé (370) en réponse au signal de déclenchement de l'appelant (340).

8. Procédé selon la revendication 1 ou 7, comprenant :
. la mise en relation du signal de déclenchement de l'appelant (340) avec la liaison vocale établie vers l'appelé (370).

9. Procédé selon la revendication 7, dans lequel un localisateur de ressource uniforme identifie un emplacement pour le contenu multimédia sélectionné à recevoir, et l'étape de transmission d'un contenu multimédia comprend :
. la transmission d'un localisateur de ressource uniforme ;
. la recherche de l'appelé (370) dans une base de données (350) d'abonnés de service ;
. la sélection du localisateur de ressource uniforme si l'appelé (370) est au moins un des abonnés de service dans la base de données (350) ; et
. l'établissement d'une première session de données pour la transmission du contenu multimédia.

10. Procédé selon la revendication 2 ou 9, dans lequel l'étape de transmission d'un localisateur de ressource uniforme comprend :
. l'établissement d'une seconde session de données pour transmettre le localisateur de ressource uniforme à l'appelant (340) ;
. la terminaison de la seconde session de données établie en réponse à l'étape d'établissement d'une liaison vocale vers l'appelé (370) ; et
. la terminaison de la première session de données établie après l'étape de terminaison de la seconde session de données établie.
